# EUROPEAN PATENT APPLICATION

(11) **EP 2 119 806 A1**
(43) Date of publication of application: **18.11.2009**
(21) Application number: 07859876.0
(22) Date of filing: 20.12.2007
(51) Int. Cl.: C23C 14/04, C23C 14/06, C23C 14/34, H01L 21/31, H01L 41/22

(54) **MULTILAYER FILM FORMING METHOD AND MULTILAYER FILM FORMING APPARATUS**

(30) Priority: 09.01.2007 JP 2007001354
(71) Applicant: Ulvac, Inc., Chigasaki-shi Kanagawa 253-8543 (JP)
(72) Inventor: KIMURA, Isao, Susono-shi Shizuoka 410-1231 (JP); JINBO, Takehito, Susono-shi Shizuoka 410-1231 (JP); KIKUCHI, Shin, Susono-shi Shizuoka 410-1231 (JP); NISHIOKA, Yutaka, Susono-shi Shizuoka 410-1231 (JP); SUU, Koukou, Susono-shi Shizuoka 410-1231 (JP)
(74) Representative: Reinhard - Skuhra - Weise & Partner GbR
(86) International application number: PCT/JP2007/074479
(87) International publication number: WO 2008/084639

(57) **Abstract**

A multilayer film formation method enables the formation of a multilayer including a complex oxide layer and having the desired shape of an element without performing an etching process. The method positions a first mask (30A) above a substrate (S), forms an adhesion layer (36) and a lower electrode layer (37) on the substrate with the first mask by sputtering an adhesion layer target (T1) and a lower electrode layer target (T2), positions a second mask (30B) formed from a ceramic material above the lower electrode layer, superimposes a complex oxide layer (38) on the lower electrode layer with the second mask by sputtering an oxide layer target (T3), positions a third mask (30C) above the complex oxide layer, and superimposes an upper electrode layer (39) on the complex oxide layer with the third mask by sputtering an upper electrode layer target (T4).

## Description

### TECHNICAL FIELD

The present invention relates to a method for forming a multilayer film and an apparatus for forming a multilayer film.

### BACKGROUND ART

Complex oxides such as lead zirconate titanate (PZT: PB(Zr,Ti)O₃) have superior piezoelectric characteristics and dielectric characteristics and are thus used in various types of electronic devices such as sensors and actuators. In the prior art, various types of elements including complex oxides are formed by machining a sinter of complex oxides.

Over recent years, in the field of electronic device fabrication, due to the miniaturization of electronic devices and progress in MEMS (Micro Electro Mechanical Systems) technology, thinner films of the above-described complex oxides are in demand. Known processes used to obtain thinner films of complex oxides include sputtering and etching, which are also used in the field of semiconductor fabrication.

In patent document 1, three different targets, which include PZT elements, are sputtered to form a PZT film. In this process, the power applied to each target is controlled. This regulates the amount of lead contained in the PZT film with high accuracy. In patent document 2, a PZT thin film undergoes dry etching. This patterns the PZT thin film. Subsequent to the patterning, the PZT film is immersed in a predetermined etching liquid. The etching liquid washes off reactive products attached to the upper surface and side surfaces of the PZT thin film. Thus, the piezoelectric characteristics and dielectric characteristics of the PZT film are the same before and after the patterning.

However, when a thin film of a lead-based complex oxide undergoes dry etching, a chlorine or fluorine etchant discharges the lead or oxygen contained in the lead-based complex oxide as lead chloride (PbCl₄ or PbCl₂) or carbon monoxide (CO). As a result, lead or oxygen is lost from the lead-based complex oxide. This increases leakage current. In this case, satisfactory piezoelectric characteristics cannot be obtained. Further, when dry etching is performed to form elements, in addition to the etching process, a process for forming a resist mask and a process for removing the resist mask become necessary. This lowers the productivity of electronic devices and increases manufacturing costs.
Patent Document 1: Japanese Laid-Open Patent Publication No. 6-57412
Patent Document 2: Japanese Laid-Open Patent Publication No. 2000-133643

### DISCLOSURE OF THE INVENTION

The present invention provides a multilayer film formation method and muitilayer film formation apparatus that allow for the formation of a multilayer including a complex oxide layer and having the desired shape of an element without performing an etching process.

A first aspect of the present invention is a multilayer film formation method. The method includes positioning a first mask above a substrate, forming a lower electrode layer on the substrate with the first mask by sputtering a first target, positioning a second mask formed from a ceramic material above the lower electrode layer, superimposing a complex oxide layer on the lower electrode layer with the second mask by sputtering a second target, positioning a third mask above the complex oxide layer, and superimposing an upper electrode layer on the complex oxide layer with the third mask by sputtering a third target.

A second aspect of the present invention is a multilayer film formation apparatus. The apparatus includes a first film formation unit which positions a first mask above a substrate, sputters a first target, and forms a lower electrode layer on the substrate with the first mask. A second film formation unit positions a second mask formed from a ceramic material above the substrate, sputters a second target, and superimposes a complex oxide layer on the lower electrode layer with the second mask. A third film formation unit positions a third mask above the complex oxide layer, sputters a third target, and superimposes an upper electrode layer on the complex oxide layer with the third mask. A transfer unit is connected to the first film formation unit, the second film formation unit, and the third film formation unit to transfer the substrate to the first film formation unit, the second film formation unit, and the third film formation unit. A control unit drives the transfer unit, the first film formation unit, the second film formation unit, and the third film formation unit to sequentially superimpose the lower electrode layer, the complex oxide layer, and the upper electrode layer on the substrate.

### BRIEF DESCRIPTION OF THE DRAWINGS

Fig. 1 is a plan view schematically showing one embodiment of a film formation apparatus;
Fig. 2 is a cross-sectional side view schematically showing the structure of a film formation chamber of Fig. 1;
Figs. 3(a) and 3(b) are respectively a plan view and a cross-sectional side view, each showing the structure of a mask;
Figs. 4(a) and 4(b) are respectively a plan view and a cross-sectional side view, each showing the structure of a mask hole;
Fig. 4(c) is a diagram showing the relationship between the mask hole and the multilayer film; and
Fig. 5 is a schematic block circuit diagram showing the electric structure of the film formation apparatus of Fig. 1.

### BEST MODE FOR CARRYING OUT THE INVENTION

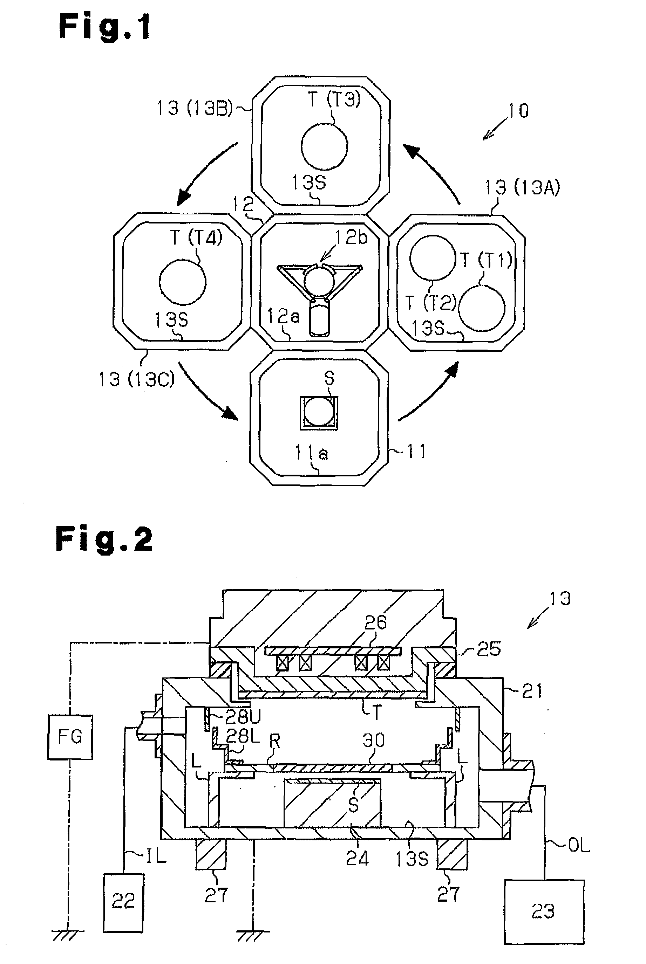

One embodiment of an apparatus for forming a multilayer film according to the present invention will now be discussed. Fig. 1 is a plan view schematically showing a film formation apparatus 10 serving as a multilayer film formation apparatus.

As shown in Fig. 1, the film formation apparatus 10 includes a load lock chamber (hereinafter simply referred to as the LL chamber) 11 and a transfer chamber 12, which is connected to the LL chamber 11 and defines a transfer unit. The film formation apparatus 10 also includes three film formation chambers 13 connected to the transfer chamber 12, namely, a first film formation chamber 13A defining a first film formation unit, a second film formation chamber 13B defining a second film formation unit, and a third film formation chamber 13C defining a third film formation unit.

The LL chamber 11 includes a depressurizable inner area (hereinafter simply referred to as an accommodation compartment 11a), which accommodates a plurality of substrates S so that they can be transferred into and out of the accommodation compartment 11a. Silicon substrates, ceramic substrates, and the like may be used as the substrates S. When starting a film formation process for the substrates S, the LL chamber 11 depressurizes the accommodation compartment 11 a so that the plurality of substrates S are transferrable out of the transfer chamber 12. After the film formation process for the substrates S ends, the LL chamber 11 opens the accommodation compartment 11a to the atmosphere so that the accommodated substrates S are transferrable out of the film formation apparatus 10.

The transfer chamber 12 includes an inner area (hereinafter simply referred to as a transfer compartment 12a), which is communicable with the accommodation compartment 11a. A transfer robot 12b is installed in the transfer compartment 12a to transfer the substrates S. When the film formation process for the substrates S starts, the transfer robot 12b loads the substrates S, which are yet to undergo the film formation process, from the LL chamber 11 to the transfer chamber 12. Then, the transfer robot 12b transfers the loaded substrates S in an order of the counterclockwise direction as viewed in Fig. 1, that is, in an order of the first film formation chamber 13A, the second film formation chamber 13B, and the third film formation chamber 13C. This continuously forms each layer without the substrates S being exposed to the atmosphere. After the film formation process for the substrates S ends, the transfer robot 12b loads the substrates S, which have undergone the film formation process, out of the transfer chamber 12 and into the LL chamber 11.

The film formation chambers 13A, 13B, and 13C each include an inner area (hereinafter simply referred to as a film formation compartment 13S), which is communicable with the transfer compartment 12a. Each film formation compartment 13S includes a corresponding target T. More particularly, the first film formation chamber 13A includes an adhesion layer target T1 and a lower electrode layer target T2, which form first targets. The second film formation chamber 13B includes an oxide layer target T3, which serves as a second target. The third film formation chamber 13C includes an upper electrode target T4, which serves as a third target.

The adhesion layer target T1 includes the main components of an adhesion layer, that is, 90% or more, and preferably, 95% or more of one of a metal selected from the group consisting of titanium (Ti), tantalum (Ta), nickel (Ni), and cobalt (Co) or either an oxide or nitride of the selected metal. The remainder of the adhesion layer target T1 includes a metal other than the above metal elements. The lower electrode layer target T2 includes the main components of a lower electrode layer, that is, 90% or more, and preferably, 95% or more of one of a noble metal selected from the group consisting of platinum (Pt), iridium (Ir), gold (Au), and silver (Ag) or either an oxide or nitride of the selected noble metal. The remainder of the lower electrode layer target T2 includes a metal other than the above metal elements, for example, copper or silicon. The oxide electrode layer target T3 includes the main components of a complex oxide electrode layer, that is, a sinter of a complex oxide such as lead zirconate titanate (Pb(Zr,Ti)O₃:PZT), lead strontium titanate (Pb(Sr,Ti)O₃:PST), and lead lanthanum zirconium titanate (Pb,La)(Zr,Ti)O₃:PLZT). The upper electrode layer target T4 includes the main components of an upper electrode layer, that is, 90% or more, and preferably, 95% or more of one of a noble metal selected from the group consisting of platinum (Pt), iridium (Ir), gold (Au), and silver (Ag) or either an oxide or nitride of the selected noble metal. The remainder of the upper electrode layer target T4 includes a metal other than the above metal elements, for example, copper or silicon.

Each film formation chamber 13 sputters the target T and forms a layer of a film corresponding to the target T on the substrate S, which is held at a predetermined temperature (e.g., a temperature of 500°C or higher). More specifically, the first film formation chamber 13A sputters the adhesion layer target T1 and the lower electrode layer target T2 to form the adhesion layer and the lower electrode layer. The second film formation chamber 13B sputters the oxide layer target T3 to form the complex oxide layer. The third film formation chamber 13C sputters the upper electrode layer target T4 to form the upper electrode layer.

Referring to Fig. 2, the film formation chamber 13 includes a main chamber body 21, which forms the film formation compartment 13S. The main chamber body 21 includes a gas supply unit 22, which is in communication with the film formation compartment 13S through a supply pipe IL. The gas supply unit 22 supplies the film formation compartment 13S with gas regulated to a predetermined flow rate in correspondence with each target T. For example, the gas supply unit 22 corresponding to the first film formation chamber 13A and the third film formation chamber 13C supplies the film formation compartments 13S with argon (Ar) gas for sputtering the adhesion layer target T1, the lower electrode layer target T2, and the upper electrode layer target T4. The gas supply unit 22 corresponding to the second film formation chamber 13B supplies the film formation compartment 13S with Ar gas for sputtering the oxide layer target T3 and oxygen (O₂) gas for providing oxygen to sputtering grains.

The film formation compartment 13S is connected to a discharge system 23, which includes a turbomolecular pump or a dry pump, via an exhaust pipe OL. The discharge system 23 discharges the Ar gas or mixture of Ar gas and O₂ gas supplied to the film formation compartment 13S and depressurizes the film formation compartment 13S to a predetermined pressure value.

The film formation compartment 13S includes a substrate stage 24, which is for holding a substrate S. The substrate stage 24 holds a substrate S that is loaded into the transfer chamber 12. This positions and fixes the substrate S at a predetermined position in the film formation compartment 13S.

The target T, which is disk-shaped, is arranged immediately above the substrate stage 24. A target electrode 25 is arranged on the upper side of the target T. The target electrode 25 holds the target T facing toward the substrate S with a predetermined distance between the target T and the substrate S. The target electrode 25 is connected to an external power supply FG and supplies the target T with predetermined DC or AC power output from an external power supply FG. When plasma is generated in the film formation compartment 13S, the target electrode 25 receiving the DC or AC current functions as a negative potential, or cathode, for the plasma area and thereby sputters the target T.

A magnetic circuit 26 is arranged at the upper side of the target electrode 25. The magnetic circuit 26 forms a magnetron field along the inner, upper surface of the target T. When plasma is generated in the film formation compartment 13S, the magnetic circuit 26 stabilizes the plasma and increases the plasma density.

When forming a thin film on a substrate S in correspondence with the target T, each of the film formation chambers 13 is supplied with a predetermined flow rate of sputter gas or a mixture of sputter gas and reactive gas from the gas supply unit 22, and the discharge system 23 depressurizes the compartment 13S to a predetermined pressure value. In this state, each film formation chamber 13 applies predetermined power to the target electrode 25 from the external power supply FG and sputters the target T with high density plasma. Sputtering grains strike and coat the surface of the substrate S.

As viewed in Fig. 2, the substrate stage 24 is located between two lifters L in the film formation compartment 13S. The two lifters I, which is connected to and driven by a lifting mechanism 27 arranged under the main chamber body 21, receives drive force from the lifting mechanism 27. This lifts or lowers the lifters 1 in a direction that is generally normal to the substrate S, that is, in the vertical direction as viewed in Fig. 2. The two lifters L arranged in each of the first film formation chamber 13A, the second film formation chamber 13B, and the third film formation chamber 13C respectively form a first movement mechanism, a second movement mechanism, and a third movement mechanism.

A common mask lifting ring R is arranged on the upper side of the two lifters L. When viewed from above or below, the mask lifting ring R is annular and surrounds the circumference of the substrate S. When the two lifters L are lifted or lowered, the mask lifting ring R is lifted or lowered together with the two lifters L in a direction normal to the substrate S. That is, the mask lifting ring R is positioned by the two lifters L and allowed to move only in the normal direction of the substrate S.

A lower adhesion prevention plate 28L, which is generally cylindrical, is arranged on the upper side of the mask lifting ring R. When the target T is being sputtered, the lower adhesion prevention plate 28L prevents sputtering grains from adhering to the inner lower wall of the opposing film formation compartment 13S. When the two lifters L are lifted or lowered, the lower adhesion prevention plate 28L is lifted or lowered together with the two lifters L in a direction normal to the substrate S.

An upper adhesion prevention plate 28U, which is generally cylindrical, is arranged at the upper side of the lower adhesion prevention plate 28L. When the target T is being sputtered, the upper adhesion prevention plate 28U prevents sputtering grains from adhering to the inner lower wall of the opposing film formation compartment 13S.

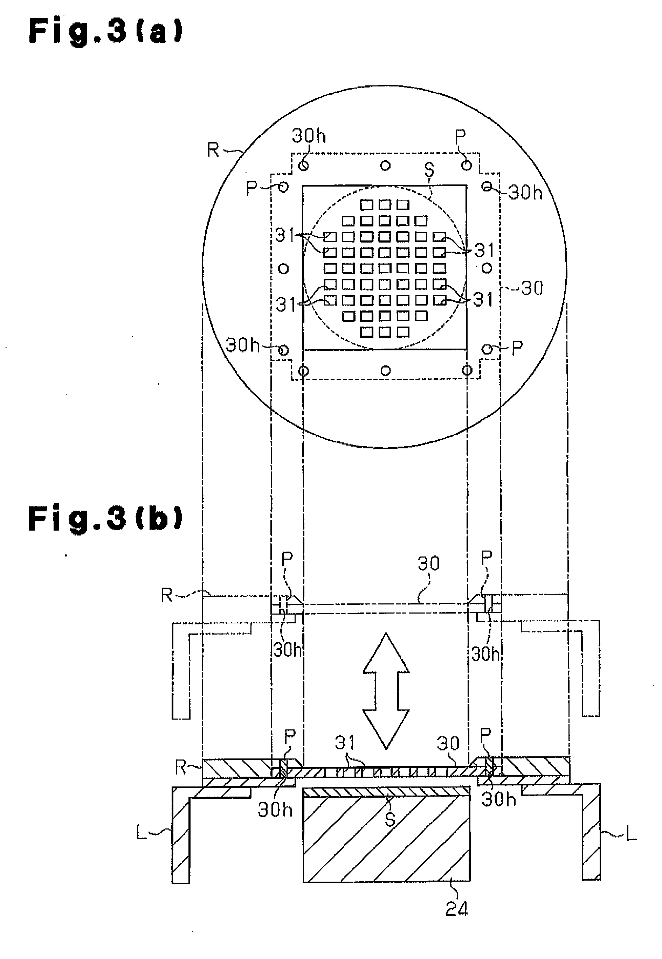

A mask 30 opposing the substrate S is arranged at the inner side of the mask lifting ring R. Fig. 3(a) is a plan view of the mask 30 as seen from the target T, and Fig. 3(b) is a cross-sectional side view of the mask 30 as seen from a planar direction of the substrate S.

The mask 30 shown in Fig. 3 is a generally tetragonal plate formed from a ceramic material (e.g., alumina (Al₂O₃)). A plurality of positioning holes 30H are arranged along the periphery of the mask 30. A positioning pin P is inserted into each positioning hole 30h through the mask lifting ring R. The insertion of the positioning pin P into each positioning hole 30h positions and fixes the mask 30 to the mask lifting ring R in a detachable manner. When the two lifters L are lifted or lowered, the mask 30 moves between a position near the substrate S (position shown by solid lines in Fig. 3(b)) and a position far above the substrate S (position shown by double-dashed lines in Fig. 3(b)). The position at which the mask 30 is located near the substrate is defined as a film formation position, and the position at which the mask 30 is located far away from the substrate is defined as a transfer position.

A plurality of mask holes 31 extend through the mask 30 in a direction normal to the substrate S. The plurality of mask holes 31 are generally formed above the entire substrate S. Each mask hole 31 is formed to have a shape corresponding to the shape of each layer, that is, a shape corresponding to the element shape.

When forming a thin film corresponding to the target T1 on the substrate S, each film formation chamber 13 positions the mask 30 at the film formation position with the lifting mechanism 27 so that the mask 30 is located near the substrate S. When the target T is sputtered, the sputtering grains pass through the mask holes 31 of the mask 30 and strike the surface of the substrate S. That is, the sputtering grains are deposited on the substrate S in accordance with the shape corresponding to the shape of each mask hole 31. When transferring the substrate S, each film formation chamber 13 positions the mask 30 at the transfer position with the lifting mechanism 27 so that the mask 30 is far away from the substrate S. Thus, each film formation chamber 13 prevents physical contact between the transferred substrate S and the mask 30.

The masks 30 corresponding to the adhesion layer target T1 and the lower electrode layer target T2 arranged in the first film formation chamber 13A are defined as first masks 30A. The mask holes 31 formed in the first masks 30A are defined as first mask holes 31A. The mask 30 corresponding to the oxide layer target T3 arranged in the second film formation chamber 13B is defined as a second mask 30B. The mask holes 31 formed in the second mask 30B are defined as second mask holes 31B. The mask 30 corresponding to the upper electrode layer target T4 arranged in the third film formation chamber 13C is defined as a third mask 30C. The mask holes 31 formed in the third mask 30C are defined as third mask holes 31C.

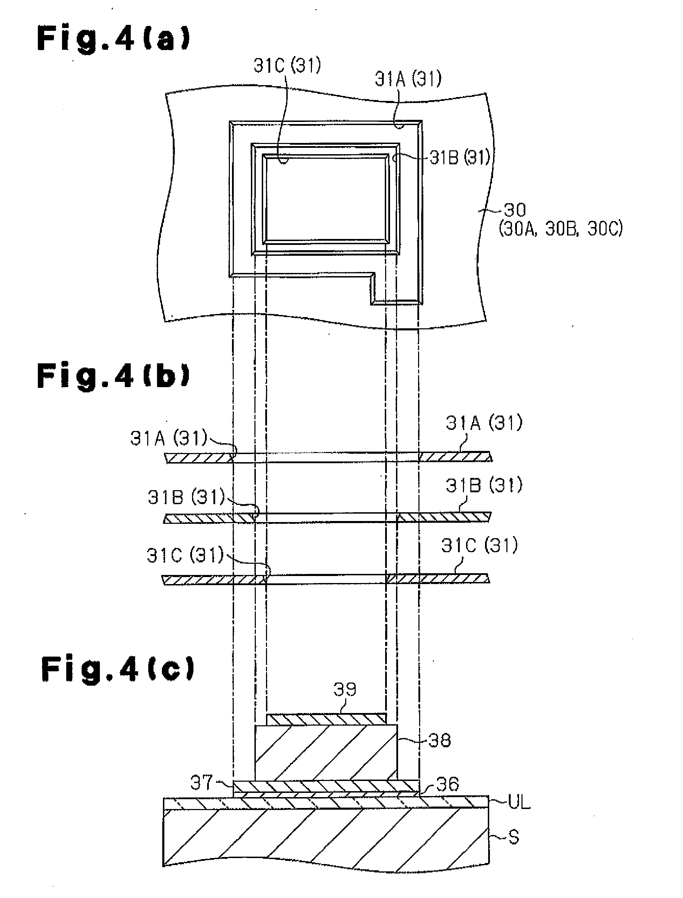

Fig. 4(a) is a plan view of a mask hole 31 of each mask 30 as viewed from the target T, and Fig. 4(b) is a cross-sectional side view of the mask hole 31 of each mask 30. Further, Fig. 4(c) is a cross-sectional side view showing a multilayer film formed with each mask 30.

As shown in Fig. 4, the first mask hole 31A is formed to be rectangular and generally tetragonal as viewed from the target T. The first mask hole 31A has tapered inner walls that widen at upward positions. When the adhesion layer target T1 is sputtered, the sputtering grains pass through the first mask hole 31A toward the substrate S, and the adhesion layer 36 deposits on the substrate S with a shape corresponding to the first mask hole 31A. In the same manner, when the lower electrode layer target T2 is sputtered, the sputtering grains pass through the first mask hole 31A toward the substrate S and the lower electrode layer 37 deposits on the substrate S, that is, on the upper side of the adhesion layer 36, with a shape corresponding to the first mask hole 31A. In this process, the tapered inner walls of the first mask hole 31A widen the range for the entrance angle of the passing sputtering grains. This forms the adhesion layer 36 and the lower electrode layer 37 with a further uniform film thickness.

The second mask hole 31 B, which is rectangular and generally tetragonal as viewed from the target T, is formed inward from the first mask hole 31A relative to a common substrate S. In other words, the second mask hole 31 B is smaller than the first mask hole 31A. In the same manner as the first mask hole 31A, the second mask hole 31 B has tapered inner walls that widen at upward positions. When the oxide layer target T3 is sputtered, the sputtering grains pass through the second mask hole 31B toward the substrate S, and the complex oxide layer 38 deposits on the substrate S with a shape corresponding to the second mask hole 31B. That is, the complex oxide layer 38 is superimposed on the upper side of the lower electrode layer 37 through the second mask hole 31 B without hanging out from the region of the lower electrode layer 37. In this process, the tapered inner walls of the second mask hole 31B widen the range for the entrance angle of the passing sputtering grains. This forms the complex oxide layer 38 with a further uniform film thickness.

Additionally, the second mask 30B is formed from a ceramic material. Thus, the difference in coefficient of thermal expansion between the second mask 30B and the complex oxide layer 38 is small. This prevents the complex oxides deposited on the second mask 30B from causing film removal as a result of the difference in coefficient of thermal expansion. That is, when superimposing the complex oxide layer 38, the second mask 30B suppresses the production of particles caused by film removal of complex oxides.

The third mask hole 31C, which is rectangular and generally tetragonal as viewed from the target T, is formed inward from the second mask hole 31B relative to a common substrate S. In other words, the third mask hole 31C is smaller than the second mask hole 31B. In the same manner as the first mask hole 31A, the third mask hole 31C has tapered inner walls that widen at upward positions. When the upper electrode layer target T4 is sputtered, the sputtering grains pass through the third mask hole 31C toward the substrate S, and the upper electrode layer 39 deposits on the substrate S with a shape corresponding to the third mask hole 31C. That is, the upper electrode layer 39 is superimposed on the upper side of the complex oxide layer 38 through the third mask hole 31C without hanging out from the region of the complex oxide layer 38. In this process, the tapered inner walls of the third mask hole 31C widen the range for the entrance angle of the passing sputtering grains. This forms the upper electrode layer 39 with a further uniform film thickness.

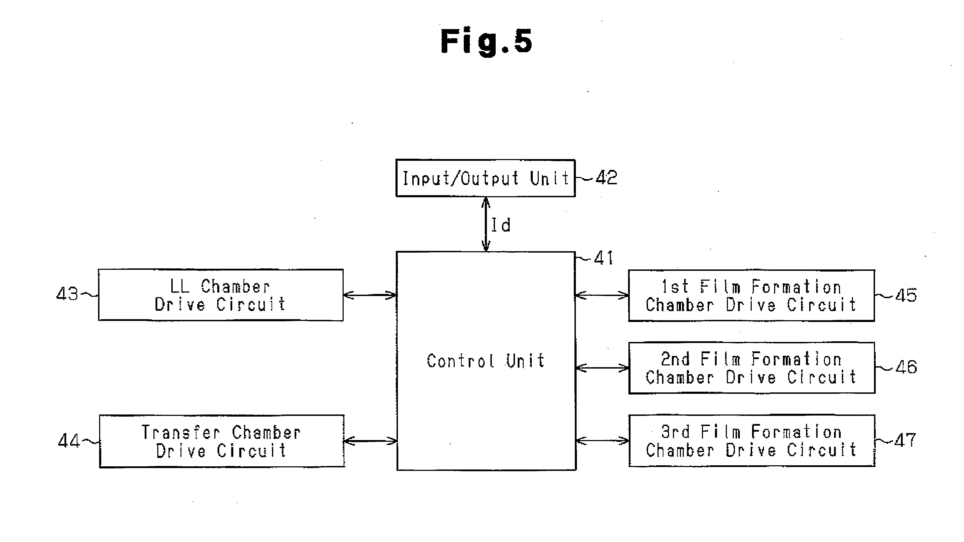

The electrical configuration of the film formation apparatus 10 will now be discussed with reference to Fig. 5. A control unit 41 executes various processes (e.g., transfer process for the substrates S, film formation process for the substrate S, etc.). The control unit 41 includes a CPU for executing various calculations, a RAM for storing various types of data, a ROM for storing various control programs, a hard disk, and the like. The control unit 41, for example, reads out a film formation process program from the hard disk to execute the film formation process in accordance with the film formation process program.

The control unit 41 is connected to an input/output unit 42. The input/output unit 42 includes various types of operation switches, such as a start switch and a stop switch, and various types of display devices, such as a liquid crystal display. The input/output unit 42 provides the control unit 41 with data used in various processing operations and outputs data related to the processing status of the film formation apparatus 10. The input/output unit 42 provides the control unit 41 with data related to film formation parameters (e.g., gas flow rate, film formation pressure, film formation temperature, film formation time, etc.) as film formation condition data Id. In other words, the input/output unit 42 provides the control unit 41 with various film formation parameters to form the adhesion layer, the lower electrode layer, the complex oxide layer, and the upper electrode layer as the film formation condition data Id. The control unit 41 executes a film formation process for each layer under film formation conditions that correspond to the film formation condition data Id provided from the input/output unit 42.

The control unit 41 is connected to an LL chamber drive circuit 43, which controls and drives the LL chamber 11. The LL chamber drive circuit 43 detects the state of the LL chamber 11 and provides the detection result to the control unit 41. For example, the LL chamber drive circuit 43 detects the pressure value of the accommodation compartment 11a and provides the control unit 41 with a detection signal related to the pressure value. Based on the detection signal provided from the LL chamber drive circuit 43, the control unit 41 provides the LL chamber drive circuit 43 with a corresponding drive control signal. In response to the drive control signal from the control unit 41, the LL chamber drive circuit 43 depressurizes or opens the accommodation compartment 11a to the atmosphere so that a substrates S can be loaded into or out of the accommodation compartment 11 a.

The control unit 41 is connected to a transfer chamber drive circuit 44, which controls and drives the transfer chamber 12. The transfer chamber drive circuit 44 detects the state of the transfer chamber 12 and provides the detection result to the control unit 41. For example, the transfer chamber drive circuit 44 detects an arm position of the transfer robot 12b and provides the control unit 41 with a detection signal related to the arm position. Based on the detection signal provided from the transfer chamber drive circuit 44, the control unit 41 provides the transfer chamber drive circuit 44 with a corresponding drive control signal. In response to the drive control signal from the control unit 41, the transfer chamber drive circuit 44 transfers the substrates S in accordance with a film formation process program in the order of the LL chamber 11, the transfer chamber 12, the first film formation chamber 13A, the second film formation chamber 13B, and the third film formation chamber 13C.

The control unit 41 is connected to a first film formation chamber drive circuit 45, which controls and drives the first film formation chamber 13A. The first film formation chamber drive circuit 45 detects the state of the first film formation chamber 13A and provides the detection result to the control unit 41. For example, the first film formation chamber drive circuit 45 detects parameters such as the actual pressure of the film formation compartment 13S, the actual flow rate of sputter gas, the actual temperature of the substrate S, the process time, the value of the actual power applied to the target T, and the position of the lifters L. Then, the first film formation chamber drive circuit 45 provides the control unit 41 with detection signals related to the parameters. Based on the detection signals provided from the first film formation chamber drive circuit 45, the control unit 41 provides the first film formation chamber drive circuit 45 with a drive control signal corresponding to the film formation condition data Id. In response to the drive control signal from the control unit 41, the first film formation chamber drive circuit 45 executes film formation processes for the adhesion layer 36 and the lower electrode layer 37 under the film formation condition corresponding to the film formation condition data Id.

The control unit 41 is connected to a second film formation chamber drive circuit 46, which controls and drives the second film formation chamber 13B. The second film formation chamber drive circuit 46 detects the state of the second film formation chamber 13B and provides the detection result to the control unit 41. For example, the second film formation chamber drive circuit 46 detects parameters such as the actual pressure of the film formation compartment 13S, the actual flow rate of sputter gas and reactive gas, the actual temperature of the substrate S, the process time, the value of the actual power applied to the target T, and the position of the lifters L. Then, the second film formation chamber drive circuit 46 provides the control unit 41 with detection signals related to the parameters. Based on the detection signals provided from the second film formation chamber drive circuit 46, the control unit 41 provides the second film formation chamber drive circuit 46 with a drive control signal corresponding to the film formation condition data Id. In response to the drive control signal from the control unit 41, the second film formation chamber drive circuit 46 executes a film formation process for the complex oxide layer 38 under the film formation condition corresponding to the film formation condition data Id.

The control unit 41 is connected to a third film formation chamber drive circuit 47, which controls and drives the third film formation chamber 13C. The third film formation chamber drive circuit 47 detects the state of the third film formation chamber 13C and provides the detection result to the control unit 41. For example, the third film formation chamber drive circuit 47 detects parameters such as the actual pressure of the film formation compartment 13S, the actual flow rate of sputter gas, the actual temperature of the substrate S, the process time, the value of the actual power applied to the target T, and the position of the lifters L. Then, the third film formation chamber drive circuit 47 provides the control unit 41 with the detection signals related to the parameters. Based on the detection signal provided from the third film formation chamber drive circuit 47, the control unit 41 provides the third film formation chamber drive circuit 47 with a drive control signal corresponding to the film formation condition data Id. In response to the drive control signal from the control unit 41, the third film formation chamber drive circuit 47 executes a film formation process for the upper electrode layer 39 under the film formation condition corresponding to the film formation condition data Id.

A method for forming a multilayer film with the film formation apparatus 10 will now be discussed.

First, the substrates S are set In the LL chamber 11. In this case, each substrate S has a surface on which an underlayer UL (e.g., silicon oxide film) is formed, as shown in Fig. 4(c). When receiving the film formation condition data Id from the input/output unit 42, the control unit 41 drives the LL chamber 11 and the transfer chamber 12 with the LL chamber drive circuit 43 and the transfer chamber drive circuit 44 to transfer a substrate S from the accommodation compartment 11a to the first film formation chamber 13A.

When the substrate S is loaded into the film formation compartment 13S of the first film formation chamber 13A, the control unit 41 sequentially superimposes an adhesion layer 36 and a lower electrode layer 37 on the upper side of the underlayer UL. In other words, the control unit 41 moves the first mask 30A, which is located at the transfer position, to the film formation position with the first film formation chamber drive circuit 45 and forms the adhesion layer 36 and the lower electrode layer 37 with the first mask hole 31A under a film formation condition corresponding to the film formation condition data Id.

After the lower electrode layer 37 is formed, the control unit 41 superimposes the complex oxide layer 38 on the upper side of the lower electrode layer 37. That is, the control unit 41 drives the transfer chamber 12 with the transfer chamber drive circuit 44 and transfers the substrate S from the first film formation chamber 13A to the second film formation chamber 13B. Then, the control unit 41 moves the second mask 30B, which is located at the transfer position, to the film formation position with the second film formation chamber drive circuit 46 and forms the complex oxide layer 38 with the second mask hole 31 B under a film formation condition corresponding to the film formation condition data Id.

After the complex oxide layer 38 is formed, the control unit 41 superimposes the upper electrode layer 39 on the upper side of the complex oxide layer 38. That is, the control unit 41 drives the transfer chamber 12 with the transfer chamber drive circuit 44 and transfers the substrate S from the second film formation chamber 13B to the third film formation chamber 13C. Then, the control unit 41 moves the third mask 30C, which is located at the transfer position, to the film formation position with the third film formation chamber drive circuit 47 and forms the upper electrode layer 39 with the third mask hole 31C under a film formation condition corresponding to the film formation condition data Id. This forms a multilayer film including the adhesion layer 36, the lower electrode layer 37, the complex oxide layer 38, and the upper electrode layer 39 with the film formation apparatus 10 without performing an etching process.

After the upper electrode layer 30 is formed, the control unit 41 transfers the substrate S out of the film formation apparatus 10. In other words, the control unit 41 drives the transfer chamber 12 with the transfer chamber drive circuit 44 to transfer the substrate S from the third film formation chamber 13C to the LL chamber 11. Afterward, in the same manner, the control unit 41 drives the chambers 11 to 15 with the drive circuits 43 to 47 to superimpose the adhesion layer 36, the lower electrode layer 37, the complex oxide layer 38, and the upper electrode layer 39 on every one of the substrates S. Then, the substrates S are accommodated in the LL chamber 11. After every one of the substrates S undergo the film formation process, the control unit 41 opens the LL chamber 11 to the atmosphere with the LL chamber drive circuit 43 and transfers all of the substrates S out of the film formation apparatus 10.

The method for forming a multilayer film in the embodiment has the advantages described below.
(1) The method for forming a multilayer in the embodiment positions the first mask 30A above the substrate S, sputters the adhesion layer target T1 and the lower electrode layer target T2, forms the adhesion layer 36 and the lower electrode layer 37 having a shape corresponding to the first mask hole 31A on the substrate S, positions the second mask 30B above the lower electrode layer 37, sputters the oxide layer target T3, superimposes the complex oxide layer 38 having a shape corresponding to the second mask hole 31B on the lower electrode layer 37, positions the third mask 30C above the complex oxide layer 38, sputters the upper electrode layer target T4, and superimposes the upper electrode layer 39 having a shape corresponding to the third mask hole 31C on the complex oxide layer 38.
   Accordingly, the adhesion layer 36 and the lower electrode layer 37 are formed with the shape of the first mask hole 31A, the complex oxide layer 38 is formed with the shape of the second mask hole 31 B, and the upper electrode layer 39 is formed with the shape of the third mask hole 31C. This forms a multilayer film, which includes the complex oxide layer 38, with the desired shape of an element without performing an etching process.
   In addition, the second mask 30B is formed from a ceramic material. This decreases the difference in coefficient of thermal expansion between the second mask 30B and the complex oxide layer 38. Thus, the complex oxides deposited on the second mask do not cause film removal as a result of the difference in coefficient of thermal expansion. Consequently, when superimposing the complex oxide layer 38, the production of particles caused by film removal of complex oxides is suppressed.
(2) When forming the adhesion layer 36 and the lower electrode layer 37, the first mask 30A is lowered from the transfer position to the film formation position so that the first mask 30A is located near the substrate S. Further, when forming the complex oxide layer 38, the second mask 30B is lowered from the transfer position to the film formation position so that the second mask 30B is located near the substrate S. When forming the upper electrode layer 39, the third mask 30C is lowered from the transfer position to the film formation position so that the third mask 30C is located near the substrate S.
   Accordingly, when the substrate S is transferred, physical contact between the substrate S and each of the masks 30 is prevented. Further, each of the adhesion layer 36, the lower electrode layer 37, the complex oxide layer 38, and the upper electrode layer 39 may be formed with a higher processing accuracy.
(3) The masks 30 are each positioned and fixed in a manner detachable from the mask lifting ring R. Thus, when performing maintenance on the film formation compartment 13S (for example, when replacing the lower adhesion prevention plate 28L or the upper adhesion prevention plate 28U), the mask 30 may be simultaneously exchanged. This further lengthens the film formation stability over a long period of time for the adhesion layer 36, the lower electrode layer 37, the complex oxide layer 38, and the upper electrode layer 39.
(4) The mask 30 is lifted and lowered by the lifters L, which is for lifting and lowering the lower adhesion prevention plate 28L. Accordingly, a separate lifting and lowering mechanism for lifting and lowering the mask is not necessary, and the film formation apparatus 10 has a simpler structure.
(5) The inner walls of each mask hole 31 are tapered so as to widen at upward positions. This widens the range for the entrance angle of the sputtering grains passing through the mask hole 31. Accordingly, the adhesion layer 36, the lower electrode layer 37, the complex oxide layer 38, and the upper electrode layer 39 are each formed with a further uniform film thickness.

The above-described embodiment may be practiced in the forms described below.

The masks 30A and 30C do not have to be formed from a ceramic material. For example, at least one of the first mask 30A and the third mask 30C may be formed from a metal material or a resin material. That is, when forming a metal layer having high adhesion, such as the lower electrode layer 37 or the upper electrode layer 39, the mask 30 does not have to be formed from a ceramic material.

Instead of lifting and lowering the mask 30, the substrate stage 24 may be lifted and lowered by the substrate stage 24 to change the distance between the substrate S and the mask 30.

Single-target sputtering, which uses a single target for sputtering, is performed for the complex oxide layer 38. However, the present invention is not limited in such a manner. For example, multiple-target sputtering, which uses multiple targets for sputtering, may be applied.

In each film formation chamber 13, DC orAC sputtering may be performed in lieu of DC or AC magnetron.

## Claims

1. A multilayer film formation method being **characterized by**:
positioning a first mask above a substrate;
forming a lower electrode layer above the substrate with the first mask by sputtering a first target;
positioning a second mask formed from a ceramic material above the lower electrode layer;
superimposing a complex oxide layer on the lower electrode layer with the second mask by sputtering a second target;
positioning a third mask above the complex oxide layer; and
superimposing an upper electrode layer on the complex oxide layer with the third mask by sputtering a third target.

2. The multilayer film formation method according to claim 1, further being
**characterized by**:
moving the first mask to a location near the substrate by moving the first mask relative to the substrate in a direction normal to the substrate when forming the lower electrode layer;
moving the second mask to a location near the substrate by moving the second mask relative to the substrate in the normal direction when forming the complex oxide layer; and
moving the third mask to a location near the substrate by moving the third mask relative to the substrate in the normal direction when forming the upper electrode layer.

3. The multilayer film formation method according to claim 1 or 2, being **characterized in that**:
said forming a lower electrode layer includes:
sputtering a target of which a main component is titanium to form an adhesion layer of which a main component is the titanium on the substrate with the first mask; and
sputtering a target of which a main component is platinum to form the lower electrode layer of which a main component is the platinum on the adhesion layer with the first mask;
said superimposing a complex oxide layer includes:
sputtering a target including at least lead to form the complex oxide layer of which a main component is lead zirconate titanate on the lower electrode layer with the second
mask; and
said superimposing an upper electrode layer includes:
sputtering a target of which a main component is platinum to form the upper electrode layer of which a main component is the platinum on the complex oxide layer with the third mask.

4. A multilayer film formation apparatus being **characterized by**:
a first film formation unit which positions a first mask above a substrate, sputters a first target, and forms a lower electrode layer above the substrate with the first mask;
a second film formation unit which positions a second mask formed from a ceramic material above the substrate, sputters a second target, and superimposes a complex oxide layer on the lower electrode layer with the second mask;
a third film formation unit which positions a third mask above the complex oxide layer, sputters a third target, and superimposes an upper electrode layer on the complex oxide layer with the third mask;
a transfer unit connected to the first film formation unit, the second film formation unit, and the third film formation unit to transfer the substrate to the first film formation unit, the second film formation unit, and the third film formation unit; and
a control unit which drives the transfer unit, the first film formation unit, the second film formation unit, and the third film formation unit to sequentially superimpose the lower electrode layer, the complex oxide layer, and the upper electrode layer on the substrate.

5. The multilayer film formation apparatus according to claim 4, being **characterized in that:**
the first film formation unit includes a first movement mechanism which moves the first mask relative to the substrate in a normal direction of the substrate to change the distance between the substrate and the first mask;
the second film formation unit includes a second movement mechanism which moves the second mask relative to the substrate in the normal direction to change the distance between the substrate and the second mask;
the third film formation unit includes a third movement mechanism which moves the third mask relative to the substrate in the normal direction to change the distance between the substrate and the third mask; and
the control unit drives the first movement mechanism to move the first mask to a location near the substrate when forming the lower electrode layer, drives the second movement mechanism to move the second mask to a location near the lower electrode layer when superimposing the complex oxide layer, and drives the third movement mechanism to move the third mask to a location near the complex oxide layer when superimposing the upper electrode layer.

6. The multilayer film formation apparatus according to claim 4 or 5, **characterized in that:**
the first target includes an adhesion layer target of which a main component is titanium and a lower electrode layer target of which a main component is platinum;
the second target includes an oxide layer target including at least lead;
the third target includes an upper electrode target of which a main component is platinum; the first film formation unit sputters the adhesion layer target and the lower electrode layer target to form the adhesion layer of which a main component is the titanium and the lower electrode layer of which a main component is the platinum on the substrate with the first mask;
the second film formation unit sputters the oxide layer target to form the complex oxide layer of which a main component is lead zirconate titanate on the lower electrode layer with the second mask; and
the third film formation unit sputters the upper electrode layer target to form the upper electrode target of which a main component is the platinum on the complex oxide layer with the third mask.
